# EUROPEAN PATENT SPECIFICATION

(11) **EP 3 530 616 B1**
(45) Date of publication and mention of the grant of the patent: **07.06.2023**
(21) Application number: 17808089.1
(22) Date of filing: 19.10.2017
(51) Int. Cl.: C01B 32/186, C01B 32/194

(54) **METHOD FOR PRODUCING A SUSPENSION OF GRAPHENE PARTICLES AND CORRESPONDING SUSPENSION**
VERFAHREN ZUR HERSTELLUNG EINER SUSPENSION ENTHALTEND GRAPHENPARTIKEL UND GRAPHENPARTIKELSUSPENSION DAVON
PROCÉDÉ DE PRÉPARATION D'UNE SUSPENSION COMPRENANT DES PARTICULES DE GRAPHÈNE ET SUSPENSION DE PARTICULES DE GRAPHÈNE CORRESPONDANTE

(30) Priority: 20.10.2016 ES 201631357
(43) Date of publication of application: 28.08.2019
(73) Proprietor: Institut Químic de Sarrià CETS Fundació Privada, 08017 Barcelona (ES); Universitat Ramon Llull, Fundacio Privada, 08022 Barcelona (ES)
(72) Inventor: COLOMINAS GUARDIA, Carles, 08017 Barcelona (ES); SEMPERE NOMEN, Bernat, 08017 Barcelona (ES)
(74) Representative: Curell Suñol S.L.P.
(86) International application number: PCT/ES2017/070697
(87) International publication number: WO 2018/073478

(56) References cited:
- WO-A1-2012/144993
- WO-A1-2012/172338
- WO-A1-2013/043120
- WO-A1-2013/062264
- WO-A2-2012/021677
- WO-A2-2012/051182
- MENG YANG ET AL: "Electronic properties and strain sensitivity of CVD-grown graphene with acetylene", JAPANESE JOURNAL OF APPLIED PHYSICS, vol. 55, no. 4S, 9 March 2016 (2016-03-09) , page 04EP05, XP055441995, JP ISSN: 0021-4922, DOI: 10.7567/JJAP.55.04EP05
- XUESONG LI ET AL: "Graphene Films with Large Domain Size by a Two-Step Chemical Vapor Deposition Process", NANO LETTERS, vol. 10, no. 11, 10 November 2010 (2010-11-10), pages 4328-4334, XP055442210, ISSN: 1530-6984, DOI: 10.1021/nl101629g

## Description

### Field of the Invention

The invention relates to a method of producing a suspension of graphene particles.

Graphene is a monolayer of pure carbon atoms arranged in a regular hexagonal pattern. It is a transparent material with high electrical and thermal conductivity, as well as high mechanical strength (about 200 times greater than that of steel).

### State of the Art

The two most common production methods are by means of exfoliation and CVD (Chemical Vapor Deposition).

Exfoliation methods basically consist of exfoliating natural graphite. Exfoliation can be done using mechanical means (by using adhesive tapes separating layers from a graphite block) or in a liquid medium (by means of providing ultrasound energy, milling, etc., and adding solvents). Natural graphite exfoliation methods generally allow obtaining small graphene particles in a large amount which are not really particles having a single layer, but rather particles having more than one layer. Therefore they have limited applications.

In CVD methods, graphene is grown on a metal substrate which acts as a catalyst. The substrate can be, for example, Cu, Ni, Rh, Ir, etc. This technique allows obtaining relatively large surfaces, but the graphene that is obtained is a polycrystalline graphene with defects in its crystalline structure. After generating the layer on the substrate, there is a transfer step for transferring the layer of the substrate to the final surface that is to be coated with graphene. In a known transfer step, the graphene layer is coated with a polymeric material.

The substrate is then removed by dissolving it in a suitable solvent (for example, an acid or an aqueous ferric chloride solution), the sheet of polymeric material with the graphene is applied on the final surface and the polymeric material is removed. This transfer method includes a plurality of steps which can furthermore contaminate the graphene and/or cause imperfections in the graphene, such as breakages, folds, etc. An alternative to dissolving the substrate basically consists of generating hydrogen bubbles in the substrate by means of an electrolysis process, which causes the detachment of the sheet with the polymeric material and the graphene layer.

Graphene is a relatively new product and a plurality of its applications, both as particles and as layers having larger or smaller dimensions, such as, for example, in batteries, conductive paints and dyes, anti-corrosion coatings, OLED (organic LED), lubricants, flexible touch screens, etc., is currently under research. It is therefore necessary to provide methods of producing high quality graphene particles (understood in many different ways: higher percentage of monolayer graphene, greater monocrystallinity, greater homogeneity with respect to properties, lower chemical contamination, etc.).

WO 2012/172338 describes a process for producing graphene by providing a plurality of metallic particles as templates for graphene formation and providing a carbon source; reacting the metallic particles and carbon source under conditions suitable for graphene formation; and forming graphene particles on the metallic particles. The graphene particles formed on the metallic particles are of a size and shape substantially corresponding to the size and shape of the metallic particles.

MENG YANG ET AL, "Electronic properties and strain sensitivity of CVD-grown graphene with acetylene", JAPANESE JOURNAL OF APPLIED PHYSICS, JP, (20160309), vol. 55, no. 4S, doi:10.7567/JJAP.55.04EP05, ISSN 0021-4922, page 04EP05, XP055441995 [I] 18,19 * Experimental methods * [A] 1-17 describes the synthesis of a uniform monolayer graphene film by low-pressure CVD (LPCVD) with acetylene gas. On the base of Raman spectroscopy measurements, it was found that up to 95% of the as-grown graphene is monolayer. The electronic properties and strain sensitivity of the LPCVD-grown graphene with acetylene were also evaluated by testing the fabricated field-effect transistors (FETs) and strain sensors. The derived carrier mobility and gauge factor are 862-1150 cm2/(V s) and 3.4, respectively, revealing the potential for high-speed FETs and strain sensor applications.

WO 2012/051182 describes the synthesis of ordered arrays of GSC's by re-growth from pre-patterned seed crystals, offering an approach for scalable fabrication of single crystal graphene devices while avoiding domain boundaries. Each graphene island is a single crystal and every graphene island is of similar size. The size of graphene island arrays can be as small as less than 1 mm² or as large as several m². The distance between each GSC island is also adjustable from several micrometers to millimeters. All of the graphene islands are addressable for devices and electrical circuit fabrication.

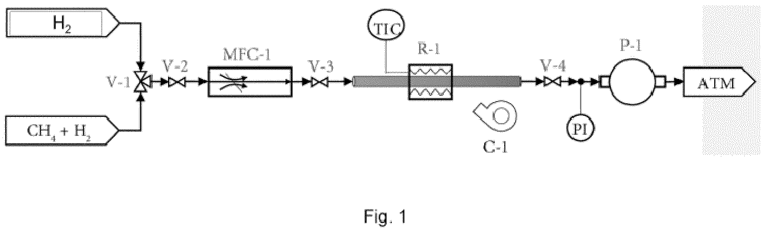

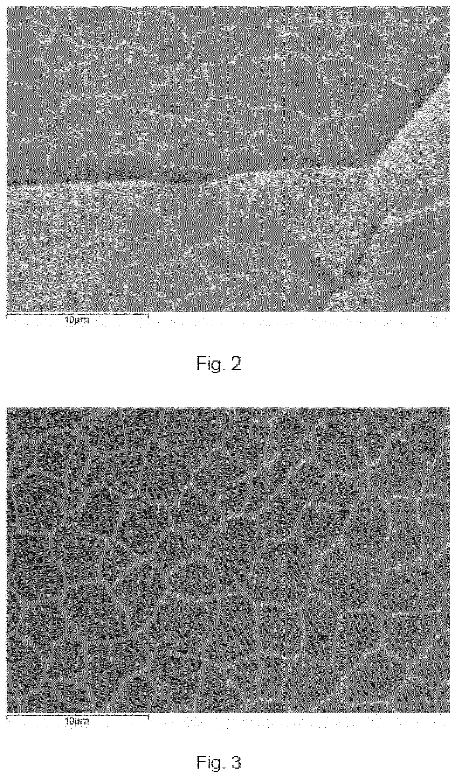

XUESONG LI ET AL, "Graphene Films with Large Domain Size by a Two-Step Chemical Vapor Deposition Process", NANO LETTERS, (20101110), vol. 10, no. 11, doi:10.1021/nl101629g, ISSN 1530-6984, pages 4328 - 4334, XP055442210 [I] 18,19 * page 4331; figures 1,3 * [A] 1-17
describes the synthesis of large area graphene by chemical vapor deposition (CVD) of methane on Cu foils, and that graphene growth on Cu is a surface-mediated process and the films were polycrystalline with domains having an area of tens of square micrometers. The paper reports on the effect of growth parameters such as temperature, and methane flow rate and partial pressure on the growth rate, domain size, and surface coverage of graphene as determined by Raman spectroscopy, and transmission and scanning electron microscopy. A two-step CVD process to synthesize graphene films with domains having an area of hundreds of square micrometers is developed. Scanning electron microscopy and Raman spectroscopy clearly show an increase in domain size by changing the growth parameters. Transmission electron microscopy further shows that the domains are crystallographically rotated with respect to each other with a range of angles from about 13 to nearly 30°. Electrical transport measurements performed on back-gated FETs show that overall films with larger domains tend to have higher carrier mobility up to about 16000 cm2 V-1 s-1 at room temperature.

### Description of the Invention

The object of the invention is to overcome these drawbacks. This object is achieved by means of a method of producing a suspension of graphene particles characterized in that it comprises the steps of:
[a] depositing carbon on a substrate by means of CVD, where graphene particles are formed on the substrate partially covering it,
[b] interrupting the deposition of carbon on the substrate before the surface of the substrate coated with graphene is more than 85% of the total surface of the substrate, preferably before the surface of the substrate coated with graphene is more than 75% of the total surface of the substrate.
[c] immersing the substrate in a liquid, and
[d] separating the graphene particles from the substrate such that they are suspended in the liquid.

Deposition generally starts in nuclei from each of which a single-crystal graphene grows. As they grow, there will come a time when these crystals come into contact with their neighboring crystals, coalescing and forming polycrystalline particles. Likewise, as the coating process progresses, the growth of a second layer on the already deposited layer will start at certain points. The basic concept of the invention consists of interrupting the substrate coating method when the substrate is coated with a plurality of graphene particles, each of them generated from a grain growth nucleus but in an "initial phase" of coating. A plurality of advantages is thereby achieved: the particles are mostly monolayer particles, the particles are mostly monocrystalline particles, defects in the crystalline structure are minimized, the method is, mechanically speaking, not very aggressive so defects such as breakages, etc., are minimized.

In the known substrate coating methods, the objective is to always obtain a continuous graphene layer, where the existence of non-coated regions is a defect that must be minimized. In the method according to the invention, the strategy is exactly the opposite: to try to prevent as much as possible the coalescing of grain growth nuclei, such that the graphene that is obtained is a plurality of particles that are independent of one another.

When reference is made to the total surface of the substrate, it must be understood as the total "useful" surface of the substrate, i.e., the surface subjected to the coating process and from which the generated particles are to be obtained.

Preferably, the substrate is a metal substrate, preferably a Cu substrate, or other metal that does not exhibit problems with hardening during the coating process. Alternatively, the substrate can have a non-metal base and a metal coating, preferably a Cu coating. Advantageously, the Cu is electropolished Cu so that the substrate has a low roughness.

The substrate can be in various forms: it can be a sheet, a wire, foam, a plurality of particles, etc.

An electrolysis causing the detachment of hydrogen on the surface of the Cu is preferably performed in step [d], such that graphene particles on the Cu are suspended in said liquid. Alternatively, the Cu can be dissolved in step [d], such that the graphene particles on the Cu are suspended in the liquid.

As mentioned above, the basic concept of the invention is to interrupt the deposition step before it has progressed "too far". As the deposition step progresses, various processes take place more or less in parallel:
- a graphene crystal grows around each growth nucleus,
- adjacent graphene crystals grow until they come into contact with one another, forming a polycrystalline particle,
- as the graphene crystals group together, there are fewer and fewer independent particles, until finally all the particles are bound together. Coalescence is complete at this point, even though the graphene layer can still exhibit discontinuities (uncoated regions or "holes")
- finally, all the holes of the graphene layer are coated and a completely continuous layer is obtained,
- in parallel, deposition of a second graphene layer on the already deposited layer starts in some particles.

There are therefore many ways to define the moment in which the deposition step must be interrupted, depending on the physical phenomenon being considered. The purpose of step [b] can therefore be characterized by many preferred ways:
- The interruption takes place before more than 30% of the graphene particles are polycrystalline particles, preferably before more than 20% of the graphene particles are polycrystalline particles.
- The interruption takes place before more than 50% of the generated graphene surface is a multilayer surface.
- The interruption takes place before the particles completely coalesce.

Advantageously, the method according to the invention comprises a step of recrystallizing the substrate or the metal coating before the deposition step and/or comprises a step of reducing surface oxides before the deposition step.

The deposition step is preferably performed in a CH₄ and H₂ atmosphere, with a CH₄ content comprised between 10% and 60%, for a time comprised between 1 and 60 minutes, at a pressure comprised between 0.01 and 1000 mbar, preferably between 0.01 and 10 mbar, and at a temperature comprised between 900ºC and 1060ºC.

Advantageously, step [b] of interrupting the deposition comprises a cooling step in which the partially coated substrate is cooled at a temperature less than 600ºC in a time less than 30 minutes, and preferably in a time less than 120 seconds. Indeed, as mentioned above, the basic concept of the invention lies in interrupting the deposition step before it progresses "too far." Given that the reaction takes place with the substrate at a high temperature, it is suitable to rapidly cool the substrate when interrupting the deposition step so that the interruption occurs at exactly the desired time.

### Brief Description of the Drawings

Other advantages and features of the invention can be seen from the following description in which the preferred embodiment/embodiments of the invention are described in reference to the attached drawings in a non-limiting manner. In the drawings:
Figure 1 shows a diagram of an installation for depositing graphene by means of CVD.
Figures 2 to 5 show the SEM (Scanning Electron Microscope) micrographs of the graphene deposited on 4 Cu substrates at 950ºC and 10% methane: sheet, wire, particles and foam, respectively.
Figures 6 to 9 show the SEM micrographs of the graphene deposited on 4 Cu substrates at 950ºC and 30% methane: sheet, wire, particles and foam, respectively.
Figure 10 shows the Tyndall effect, graphene-free solution.
Figures 11 to 13 show the Tyndall effect, solutions with graphene in suspension.
Figures 14 and 15 show SEM micrographs of a Cu wire before and after the separation step.

### Detailed Description of Several Embodiments of the Invention

Figure 1 shows a diagram of the installation for depositing graphene used in the present invention. It has a hydrogen (H₂) source and a source of methane and hydrogen (CH₄ + H₂) mixtures which are connected to a 3-way valve V-1 and feed a reactor R-1. A mass flow controller MFC-1, with its corresponding ball valves V-2 and V-3, is located at the inlet of the reactor R-1. The reactor E-1 has a temperature indicator and controller TIC. A globe valve V-4, a pressure sensor PI and a vacuum pump P-1 discharging suctioned gases into the atmosphere ATM are located at the outlet of the reactor R-1. The installation also has cooling means schematically depicted as C-1.

### Examples:

Graphene was deposited by means of CVD on different Cu substrates: sheet, wire, particles and foam under the following conditions:
Time: 10 minutes
Temperature: 950ºC
Pressure: 2.5-2.6 mbar

Rapid heating and cooling. Specifically, the partially coated substrate was cooled to 700ºC in 10 seconds and to 400ºC in 30 seconds after the indicated reaction time in both cases.

In all cases, the substrates were washed with ultrasounds and electropolished in a 50% (v/v) aqueous phosphoric acid solution at 2 V (volts) for a period between about 5 and 20 minutes (6 minutes for wire, 8 minutes for sheet and foam, 15 minutes for particles).

In all cases, the substrates were subjected to treatment in an H₂ atmosphere at 0.7 mbar and 950ºC for 15 minutes before starting the deposition step. This treatment aims to eliminate the surface oxide layer and to grow Cu grains.

The atmosphere of the reactor is changed for an atmosphere that is a mixture of hydrogen and methane.

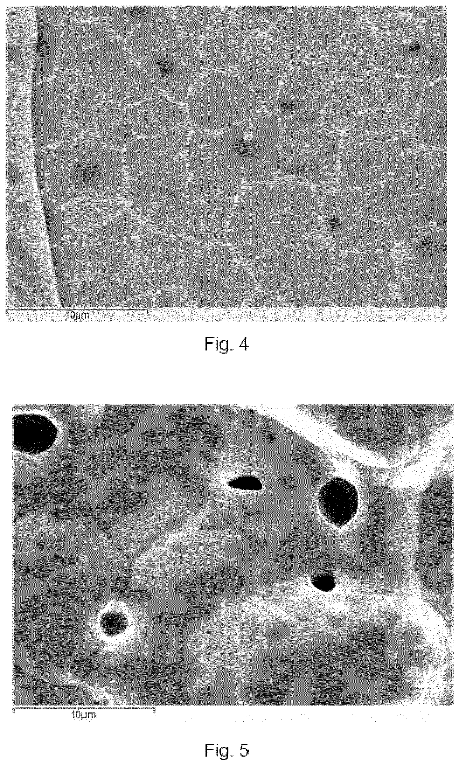

The methane concentration in a first test group was 10% (10% methane, 90% hydrogen). The results are shown in Figures 2 to 5. It can be seen that the foam substrate yields the worst results.

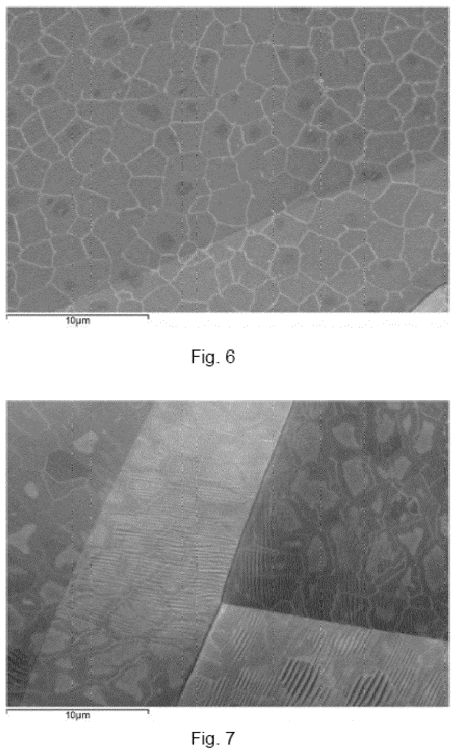

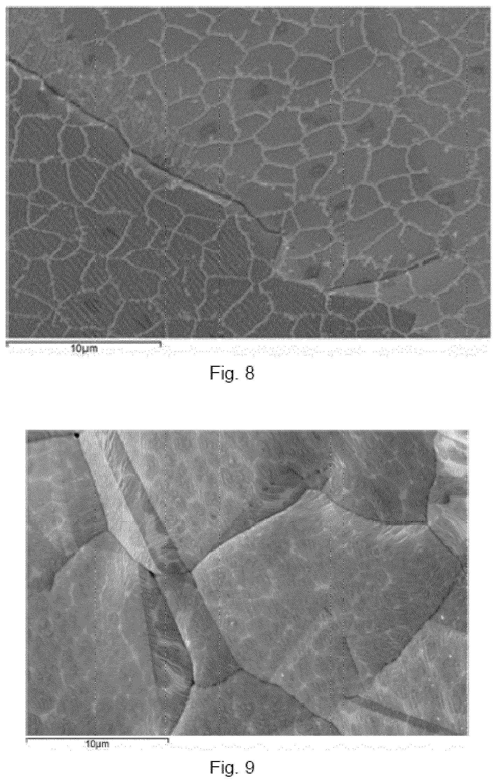

The methane concentration in a second test group was 30% (the rest being hydrogen). The results are shown in Figures 6 to 9. It can be seen that the graphene particles are closer together, but they do not completely coalesce. It can also be seen that there is more nucleation and that the particles are smaller. The results obtained in the 4 substrates are the same.

### Preparation of suspensions:

Samples of graphene prepared on a copper wire were subjected to the following electrolytic process:
- Solution: MilliQ^{®} water and 0.25 M ammonium nitrate (NH₄NO₃) to attain a conductivity of 11.2 mS
- Electrochemical assembly:
   ∘ Anode: substrate partially coated with graphene
   ∘ Ti cathode
- 5 V are applied for 5 minutes
- The suspensions are analyzed with a laser and the Tyndall effect (light scattering due to the presence of particles in suspension).

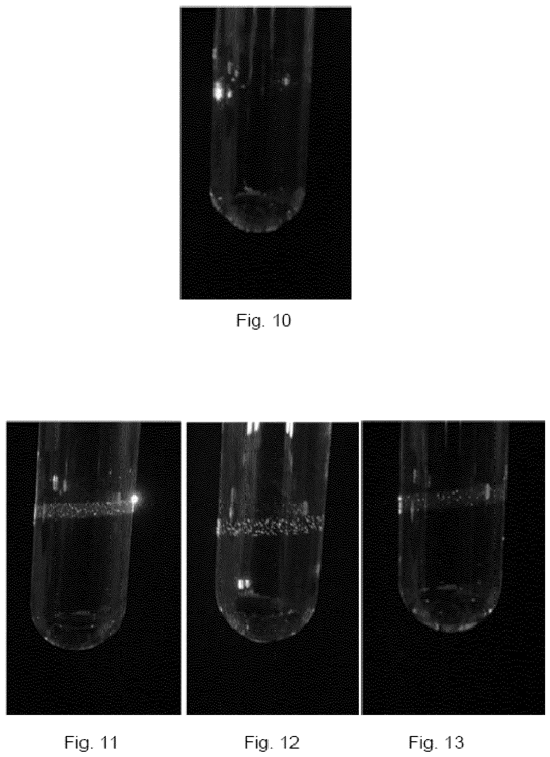

The results are shown in Figures 10 to 13. Figure 10 represents the case without graphene and Figures 11 to 13 correspond to solutions with graphene. A laser beam can be clearly seen going through the test tube. This means that there are particles in suspension. "Bright spots" corresponding to larger particles can also be seen.

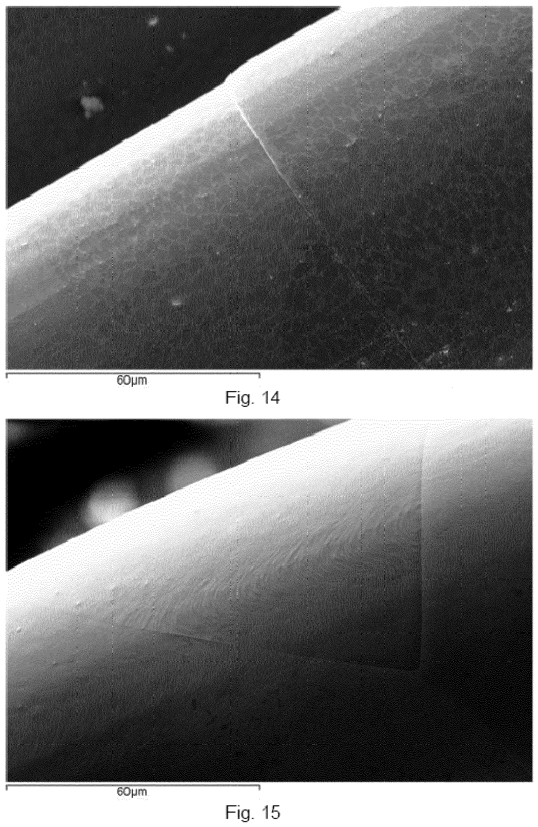

Figure 14 shows a Cu wire on which graphene has been deposited under the following conditions:
- 10 minutes of reaction
- 10% methane (the rest being hydrogen)
- 1000ºC

Graphene was separated like in the preceding case but with 0.25 M NaOH as an electrolyte (conductivity of 24.8 mS). Figure 15 shows the Cu wire after the separation step.

## Claims

1. A method of producing a suspension of graphene particles, **characterized in that** it comprises the steps of:
[a] depositing carbon on a substrate by means of CVD, where graphene particles are formed on said substrate partially covering it,
[b] interrupting the deposition of carbon on said substrate before the surface of the substrate coated with graphene is more than 85% of the total surface of the substrate, preferably before the surface of the substrate coated with graphene is more than 75% of the total surface of the substrate,
[c] immersing said substrate in a liquid, and
[d] separating said graphene particles from said substrate such that they are suspended in said liquid.

2. The method according to claim 1, **characterized in that** said substrate is a metal substrate, preferably a Cu substrate.

3. The method according to claim 1, **characterized in that** said substrate has a non-metal base and a metal coating, said coating preferably being a Cu coating.

4. The method according to one of claims 2 or 3, **characterized in that** said Cu is electropolished Cu.

5. The method according to any one of claims 1 to 4, **characterized in that** said substrate is formed by a sheet, by a wire, by foam or by a plurality of particles.

6. The method according to any one of claims 1 to 5, **characterized in that** the Cu is dissolved in said step [d], such that the graphene particles on the Cu are suspended in said liquid.

7. The method according to any one of claims 1 to 5, **characterized in that** an electrolysis causing the detachment of hydrogen on the surface of the Cu is performed in said step [d], such that the graphene particles on the Cu are suspended in said liquid.

8. The method according to any one of claims 1 to 7, **characterized in that** the interruption in said step [b] takes place before more than 30% of the graphene particles are polycrystalline particles, preferably before more than 20% of the graphene particles are polycrystalline particles.

9. The method according to any one of claims 1 to 7, **characterized in that** the interruption in said step [b] takes place before more than 50% of the generated graphene surface is a multilayer surface.

10. The method according to any one of claims 1 to 7, **characterized in that** the interruption in said step [b] takes place before said particles have completely coalesced.

11. The method according to any one of claims 1 to 10, **characterized in that** it comprises a step of recrystallizing said substrate or said metal coating before said deposition step.

12. The method according to any one of claims 1 to 11, **characterized in that** it comprises a step of reducing surface oxides before the deposition step.

13. The method according to any one of claims 1 to 12, **characterized in that** said deposition step is performed in a CH₄ and H₂ atmosphere, with a CH₄ content comprised between 10% and 60%, for a time comprised between 1 and 60 minutes, at a pressure comprised between 0.01 and 1000 mbar, preferably between 0.01 and 10 mbar, and at a temperature comprised between 900°C and 1060°C.

14. The method according to any one of claims 1 to 13, **characterized in that** said step [b] of interrupting the deposition comprises a cooling step in which the partially coated substrate is cooled at a temperature less than 600°C in a time less than 30 minutes, and preferably in a time less than 120 seconds.

## Patentansprüche

1. Verfahren zur Herstellung einer Suspension von Graphenteilchen, **dadurch gekennzeichnet, dass** es die Schritte umfasst:
[a] Abscheiden von Kohlenstoff auf einem Substrat mittels CVD, wobei Graphenteilchen auf dem Substrat gebildet werden und es teilweise bedecken,
[b] Unterbrechen der Abscheidung von Kohlenstoff auf dem Substrat, bevor die Oberfläche des Substrats, die mit Graphen beschichtet ist, mehr als 85 % der Gesamtoberfläche des Substrats beträgt, vorzugsweise bevor die Oberfläche des Substrats, die mit Graphen beschichtet ist, mehr als 75 % der Gesamtoberfläche des Substrats beträgt,
[c] Eintauchen des Substrats in eine Flüssigkeit, und
[d] Trennen der Graphenteilchen von dem Substrat, so dass sie in der Flüssigkeit suspendiert werden.

2. Verfahren nach Anspruch 1, **dadurch gekennzeichnet, dass** das Substrat ein Metallsubstrat, vorzugsweise ein Cu-Substrat, ist.

3. Verfahren nach Anspruch 1, **dadurch gekennzeichnet, dass** das Substrat eine Nicht-MetallBasis und eine Metallbeschichtung aufweist, wobei die Beschichtung vorzugsweise eine Cu-Beschichtung ist.

4. Verfahren nach Anspruch 2 oder 3, **dadurch gekennzeichnet, dass** das Cu elektropoliertes Cu ist.

5. Verfahren nach einem der Ansprüche 1 bis 4, **dadurch gekennzeichnet, dass** das Substrat aus einer Lage oder Folie, aus einem Draht, aus einem Schaum oder einer Mehrzahl von Teilchen ausgebildet ist.

6. Verfahren nach einem der Ansprüche 1 bis 5, **dadurch gekennzeichnet, dass** das Cu in dem Schritt [d] derart gelöst wird, dass die Graphenteilchen auf dem Cu in der Flüssigkeit suspendiert werden.

7. Verfahren nach einem der Ansprüche 1 bis 5, **dadurch gekennzeichnet, dass** in dem Schritt [d] eine Elektrolyse durchgeführt wird, die das Ablösen von Wasserstoff auf der Oberfläche des Cu verursacht, so dass die Graphenteilchen auf dem Cu in der Flüssigkeit suspendiert sind.

8. Verfahren nach einem der Ansprüche 1 bis 7, **dadurch gekennzeichnet, dass** die Unterbrechung in dem Schritt [b] stattfindet, bevor mehr als 30 % der Graphenteilchen polykristalline Teilchen sind, vorzugsweise bevor mehr als 20 % der Graphenteilchen polykristalline Teilchen sind.

9. Verfahren nach einem der Ansprüche 1 bis 7, **dadurch gekennzeichnet, dass** die Unterbrechung in dem Schritt [b] stattfindet, bevor mehr als 50 % der erzeugten Graphenoberfläche eine Mehrschichtoberfläche sind.

10. Verfahren nach einem der Ansprüche 1 bis 7, **dadurch gekennzeichnet, dass** die Unterbrechung in dem Schritt [b] stattfindet, bevor sich die Teilchen vollständig vereinigt haben.

11. Verfahren nach einem der Ansprüche 1 bis 10, **dadurch gekennzeichnet, dass** es einen Schritt des Rekristallisierens des Substrats oder der Metallbeschichtung vor dem Abscheidungsschritt umfasst.

12. Verfahren nach einem der Ansprüche 1 bis 11, **dadurch gekennzeichnet, dass** es einen Schritt des Verminderns von Oberflächenoxiden vor dem Abscheidungsschritt umfasst.

13. Verfahren nach einem der Ansprüche 1 bis 12, **dadurch gekennzeichnet, dass** der Abscheidungsschritt in einer CH₄- und H₂-Atmosphäre, deren CH₄-Gehalt zwischen 10 % und 60 % beträgt, für eine Zeit zwischen 1 und 60 Minute(n) bei einem Druck zwischen 0,01 und 1000 mbar, vorzugsweise zwischen 0,01 und 10 mbar, und bei einer Temperatur zwischen 900 °C und 1060 °C durchgeführt wird.

14. Verfahren nach einem der Ansprüche 1 bis 13, **dadurch gekennzeichnet, dass** der Schritt [b] des Unterbrechens der Abscheidung einen Abkühlungsschritt umfasst, in dem das teilweise beschichtete Substrat bei einer Temperatur von weniger als 600 °C in einer Zeit von weniger als 30 Minuten und vorzugsweise in einer Zeit von weniger als 120 Sekunden abgekühlt wird.

## Revendications

1. Procédé de production d'une suspension de particules de graphène, **caractérisé en ce qu'**il comprend les étapes consistant à :
[a] déposer le carbone sur un substrat par CVD, où des particules de graphène sont formées sur ledit substrat le recouvrant partiellement,
[b] interrompre le dépôt de carbone sur ledit substrat avant que la surface du substrat revêtu de graphène ne soit supérieure à 85 % de la surface totale du substrat, de préférence avant que la surface du substrat revêtu de graphène ne soit supérieure à 75 % de la surface totale du substrat,
[c] immerger ledit substrat dans un liquide, et
[d] séparer lesdites particules de graphène à partir dudit substrat pour qu'elles soient en suspension dans ledit liquide.

2. Procédé selon la revendication 1, **caractérisé en ce que** ledit substrat est un substrat métallique, de préférence un substrat en Cu.

3. Procédé selon la revendication 1, **caractérisé en ce que** ledit substrat présente une base non métallique et un revêtement métallique, ledit revêtement étant de préférence un revêtement en Cu.

4. Procédé selon l'une des revendications 2 ou 3, **caractérisé en ce que** ledit Cu est du Cu électropoli.

5. Procédé selon l'une quelconque des revendications 1 à 4, **caractérisé en ce que** ledit substrat est formé par une feuille, par un fil, par une mousse ou par une pluralité de particules.

6. Procédé selon l'une quelconque des revendications 1 à 5, **caractérisé en ce que** le Cu est dissous dans ladite étape [d], de sorte que les particules de graphène sur le Cu sont en suspension dans ledit liquide.

7. Procédé selon l'une quelconque des revendications 1 à 5, **caractérisé en ce qu'**une électrolyse provoquant le détachement d'hydrogène sur la surface du Cu est effectuée dans ladite étape [d], de sorte que les particules de graphène sur le Cu sont en suspension dans ledit liquide.

8. Procédé selon l'une quelconque des revendications 1 à 7, **caractérisé en ce que** l'interruption dans ladite étape [b] a lieu avant que plus de 30 % des particules de graphène ne soient des particules polycristallines, de préférence avant que plus de 20 % des particules de graphène ne soient des particules polycristallines.

9. Procédé selon l'une quelconque des revendications 1 à 7, **caractérisé en ce que** l'interruption dans ladite étape [b] a lieu avant que plus de 50 % de la surface de graphène générée ne soit une surface multicouche.

10. Procédé selon l'une quelconque des revendications 1 à 7, **caractérisé en ce que** l'interruption dans ladite étape [b] a lieu avant que lesdites particules aient complètement coalescé.

11. Procédé selon l'une quelconque des revendications 1 à 10, **caractérisé en ce qu'**il comprend une étape de recristallisation dudit substrat ou dudit revêtement métallique avant ladite étape de dépôt.

12. Procédé selon l'une quelconque des revendications 1 à 11, **caractérisé en ce qu'**il comprend une étape de réduction des oxydes de surface avant l'étape de dépôt.

13. Procédé selon l'une quelconque des revendications 1 à 12, **caractérisé en ce que** ladite étape de dépôt est effectuée dans une atmosphère de CH₄ et de H₂, avec une teneur en CH₄ comprise entre 10 % et 60 %, pendant une durée comprise entre 1 et 60 minutes, à une pression comprise entre 0,01 et 1000 mbar, de préférence entre 0,01 et 10 mbar, et à une température comprise entre 900 °C et 1060 °C.

14. Procédé selon l'une quelconque des revendications 1 à 13, **caractérisé en ce que** ladite étape [b] d'interruption du dépôt comprend une étape de refroidissement dans laquelle le substrat partiellement revêtu est refroidi à une température inférieure à 600 °C en un temps inférieur à 30 minutes, et de préférence en un temps inférieur à 120 secondes.
